# FASCICULE DE BREVET EUROPEEN

(11) **EP 1 895 313 B1**
(45) Date de publication et mention de la délivrance du brevet: **25.03.2009**
(21) Numéro de dépôt: 07301327.8
(22) Date de dépôt: 27.08.2007
(51) Int. Cl.: G01R 31/36, G01R 31/00

(54) **Procédé et dispositif d'aide au diagnostic d'une panne batterie d'un véhicule automobile**
Verfahren und Hilfsvorrichtung für die Pannendiagnostik der Batterie eines Kraftfahrzeugs
Method and device to help diagnose battery failure in an automobile vehicle

(30) Priorité: 29.08.2006 FR 0653497
(43) Date de publication de la demande: 05.03.2008
(73) Titulaire: PEUGEOT CITROËN AUTOMOBILES S.A., 78140 Vélizy Villacoublay (FR)
(72) Inventeur: Ragot, Franck, 75009, PARIS (FR); Monnier, Erwan, 27210, FIQUEFLEUR EQUAINVILLE (FR)

(56) Documents cités:
- EP-A- 1 598 913
- US-A1- 2003 038 637
- US-A1- 2003 105 564
- US-A1- 2005 212 521

## Description

L'invention se rapporte à un procédé et un dispositif d'aide au diagnostic d'une panne batterie d'un véhicule automobile.
Aujourd'hui, il n'existe pas d'outil permettant d'assister le technicien dans l'analyse d'une « panne batterie ». On entend par « panne batterie » une immobilisation du véhicule résultant d'une impossibilité de le démarrer et pouvant être assimilée par l'utilisateur comme étant un manque de puissance électrique pour le démarrage.

La batterie est alors souvent déchargée, rarement défaillante. Le technicien ne dispose alors d'aucune information concernant la sollicitation des ressources énergétiques du véhicule par son utilisateur.

La contrainte temporelle et le manque d'informations font que les remplacements de batteries ne sont souvent qu'une solution de facilité. En effet, les remplacements éliminent, le cas échéant, le symptôme sans pour autant corriger la véritable cause de la panne favorisant ainsi les récidives (réapparition de la panne après une nouvelle décharge de la batterie). Ces remplacements sont coûteux.

Actuellement, le technicien doit suivre une « gamme » sous format papier pour intervenir sur une panne batterie. La gamme est un guide d'assistance pour un opérateur amené à intervenir sur une panne de véhicule automobile. II choisit la gamme à suivre en fonction des symptômes qui caractérisent la panne. Ce guide répertorie l'ensemble des tâches que l'opérateur doit effectuer. Dans le cas d'une panne de batterie, l'opérateur dispose à l'heure actuelle d'une gamme imprimée générique qui préconise toutes les actions à effectuer dans l'ordre (par exemple : « vérifier que les cosses de batterie sont bien ajustées », etc.).

La gamme préconise une première action au technicien puis une deuxième action en fonction des résultats de l'action précédente. Au final, une cause probable est attribuée à la « panne batterie » et une action corrective est préconisée. La « gamme » utilisée par le technicien peut s'avérer inadaptée ou insuffisante (en cas de récidive notamment) et elle n'est pas toujours appliquée. En outre, il n'existe pas de moyen de contrôle pour s'assurer que cette gamme a été réalisée correctement lors de l'intervention.

Le document US 2003/0038637 décrit un appareil et une méthode permettant de tester une batterie et/ou un système électrique d'un véhicule automobile grâce à un dispositif de diagnostic qui, lorsqu'il est couplé au système électrique du véhicule, permet de collecter des données. Après une période de test, le dispositif de diagnostic est désaccouplé et les données collectées peuvent être analysées pour identifier les pannes ou leurs symptômes.

Le but de la présente invention est de pallier les inconvénients cités précédemment en totalité ou en partie en apportant une aide au diagnostic des « pannes batteries » qui assiste le technicien en le guidant pour identifier la véritable cause de l'immobilisation du véhicule.

L'invention a également pour objet de proposer un dispositif pour la mise en oeuvre du procédé d'aide au diagnostic des « pannes batterie ».

A cet effet, l'invention se rapporte à un procédé d'aide au diagnostic d'une panne batterie d'un véhicule, notamment automobile, comportant une première étape de prétraitement consistant à recueillir des données représentatives de l'utilisation de l'énergie électrique du véhicule lors de son utilisation et une deuxième étape de post-traitement consistant à analyser les données lors d'une panne du véhicule afin d'en identifier l'origine caractérisé en ce que l'étape de prétraitement comporte les étapes suivantes :
a. recueil et/ou calcul des données ;
b. enregistrement sur une mémoire tournante des données afin de constituer une série de données soit :
   i. consécutivement à l'intervalle de temps séparant deux démarrages du véhicule et/ou
   ii. lorsque les données à enregistrer sont disponibles et/ou
   iii. lorsque la tension d'alimentation du calculateur principal du véhicule est inférieure à une tension seuil prédéterminée et

- archivage des séries de données sur une mémoire d'archivage lorsque la tension est inférieure à une tension seuil.

Conformément à d'autres caractéristiques avantageuses de l'invention :
- l'étape de prétraitement permet d'enregistrer jusqu'à 20 séries de données sur une mémoire tournante ;
- l'étape de prétraitement permet d'archiver jusqu'à 20 séries de données sur une mémoire d'archivage ;
- l'étape de post-traitement comporte les étapes suivantes :
   i. acquisition des séries de données enregistrées et archivées lors de l'étape de prétraitement ;
   ii. analyse des données ;
   iii. détermination de l'origine possible de la panne et
   iv. préconisation d'une action corrective.
- les valeurs de la tension, de l'état de charge et de la température de la batterie sont mesurées ou estimées puis transmises au calculateur principal du véhicule pour être ajoutées aux données ;
- la valeur du courant de veille est mesurée et transmise au calculateur principal du véhicule pour être ajoutée aux données ;
- l'analyse des données réalisée lors de l'étape de post-traitement consiste à comparer les données acquises aux données de référence relatives au dimensionnement électrique du véhicule fournies par le constructeur du véhicule afin de vérifier leur conformité ;
- l'analyse des données réalisée lors de l'étape de post-traitement consiste à comparer la durée d'alimentation d'une fonction ou d'un organe du véhicule à la durée d'alimentation préconisée par le constructeur du véhicule ;
- l'analyse des données réalisée lors de l'étape de post-traitement consiste à comparer la valeur du courant de veille minimum mesurée à la valeur du courant de veille préconisée par le constructeur du véhicule ;
- la consommation électrique moyenne du véhicule durant une phase de vie est estimée et catégorisée lors de l'étape de post-traitement afin de permettre d'identifier l'origine d'une consommation électrique élevée ;
- une alerte est affichée sur l'interface homme machine lorsque les données ne sont pas conformes aux données de référence ;
- une alerte est affichée sur l'interface homme machine lorsque la tension d'alimentation du calculateur principal du véhicule n'a pas excédé la tension seuil pendant les derniers roulages enregistrés ;
- une alerte est affichée sur l'interface homme machine lorsqu'il y a eu une coupure de la tension alimentant la batterie au cours des derniers roulages enregistrés ;
- les alertes émises sont triées par degré de priorité et affichées sur l'interface homme machine selon cet ordre de priorité.

L'invention se rapporte également à un dispositif de mise en oeuvre du procédé d'aide au diagnostic comprenant un calculateur principal et une mémoire non-volatile à l'intérieur du véhicule caractérisé en ce qu'il comporte un outil de diagnostic indépendamment du véhicule.

Selon, d'autres caractéristiques dudit dispositif :
- la mémoire non-volatile comporte une partie dédiée à une mémoire tournante et une partie dédiée à une mémoire d'archivage ;
- le dispositif peut comprendre des capteurs aptes à capturer des données provenant du véhicule ;
- l'outil de diagnostic est relié au calculateur principal par des moyens de connexion et en ce qu'il comprend une unité centrale, des moyens d'acquisition et d'écriture des données, une interface homme machine permettant de faire le lien entre l'opérateur et l'outil de diagnostic et une unité de post-traitement ;
- l'outil de diagnostic réalise les étapes du post-traitement ;
- le dispositif comprend également un boîtier d'état de charge de la batterie apte à mesurer la valeur du courant de veille, la tension, l'état de charge et la température de la batterie d'autre part et à les transmettre au calculateur principal pour ajouter ces valeurs aux données afin de faciliter le diagnostic de l'énergie électrique du véhicule.

D'autres particularités et avantages ressortiront clairement de la description qui en est faite ci-après, à titre indicatif et nullement limitatif, en référence aux dessins annexés, dans lesquels :
- la figure 1 est une figure schématique du dispositif selon l'invention
- la figure 2 est un organigramme du procédé selon l'invention

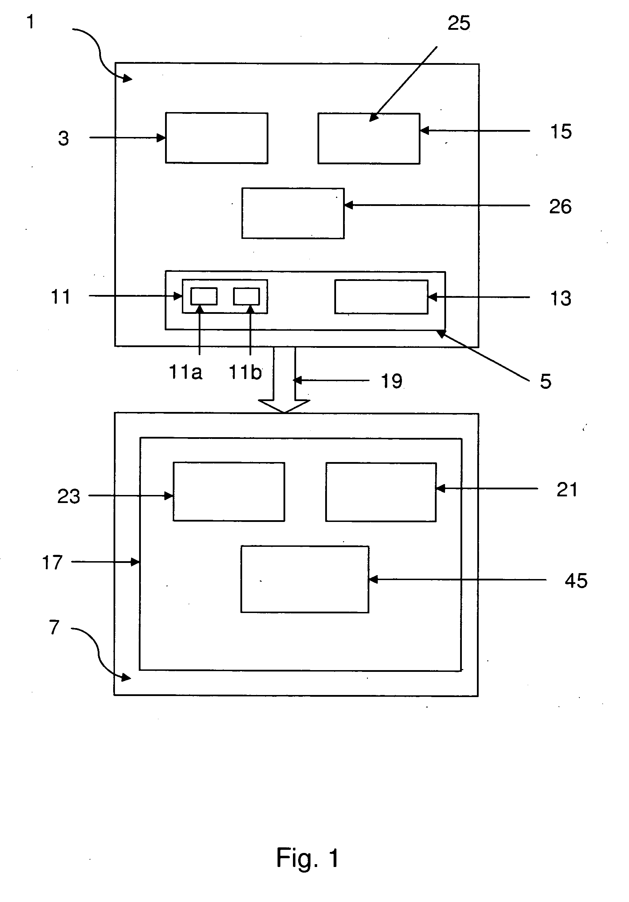

Selon la figure 1, le dispositif d'aide au diagnostic d'une panne pouvant provenir de la batterie 26 d'un véhicule 1 comprend, à l'intérieur de ce dernier, un calculateur principal 3 et une mémoire non-volatile 5. Le dispositif comprend en outre, à l'extérieur du véhicule 1 , un outil de diagnostic 7.

Le calculateur principal 3 est constitué d'interface de communication et d'une puissance de calcul pour s'interfacer avec les autres calculateurs présents sur le système, recueillir et traiter des données.

Pour les besoins de la mise en oeuvre du procédé d'aide au diagnostic, la mémoire non-volatile 5 comprend notamment une mémoire tournante 11 et une mémoire d'archivage 13.

La mémoire tournante 11 permet d'enregistrer une certaine quantité de données de façon temporaire. Au-delà de la capacité d'enregistrement permise par la mémoire tournante, les premières données à avoir été enregistrées sont effacées au profit de nouvelles données.

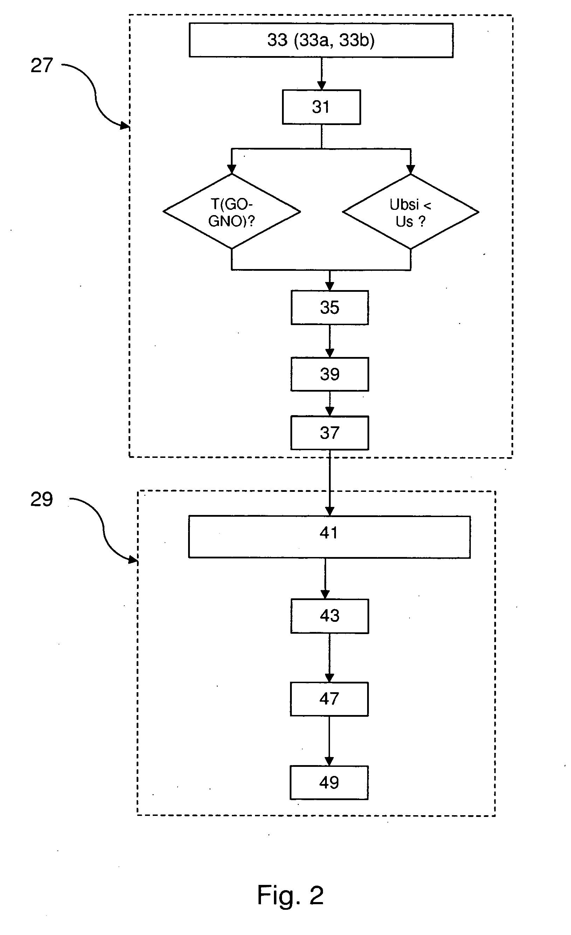

En particulier, la mémoire tournante 11 permet d'enregistrer des données correspondant à vingt « roulages » successifs. Lorsque le véhicule démarre, le générateur de courant rentrant dans la batterie 26 du véhicule 1 est opérationnel ou « générateur opérationnel » (GO). A l'inverse, lorsque le véhicule s'arrête, le générateur de courant n'est plus opérationnel ou « générateur non opérationnel » (GNO). Un « roulage » correspond à l'intervalle de temps séparant le début de deux phases consécutives. En d'autres termes, on entend par « roulage » l'intervalle de temps séparant deux démarrages consécutifs du véhicule 1 constitué par une phase GO puis une phase GNO. Cet intervalle de temps est désigné par T(GO-GNO) sur la figure 2.

De préférence, la mémoire tournante enregistre des données correspondant à dix roulages successifs.

La mémoire d'archivage 13, en revanche, permet de conserver des données enregistrées dans la mémoire tournante 11 tant qu'aucune autre panne n'est détectée : les données plus récentes viennent alors remplacer les anciens enregistrements.

La mémoire tournante 11 peut comporter au moins deux espaces distincts. Le premier espace de la mémoire tournante 11 a est dédié à l'enregistrement de premières données qui sont disponibles à tout moment. Le deuxième espace de la mémoire tournante 11 b est dédié à l'enregistrement de deuxièmes données qui ne sont pas toujours disponibles, celles-ci n'étant par conséquent enregistrées que lorsqu'elles sont disponibles.

Le dispositif peut de préférence comprendre des capteurs 15 qui sont situés à l'intérieur du véhicule. Ces capteurs mesurent des données telles que des tensions, courants ou températures par exemple.

Les capteurs 15 peuvent avantageusement comporter, à l'intérieur du véhicule 1 , un boîtier d'état de charge 25 de la batterie 26 du véhicule 1. Ce boîtier 25 permet de mesurer la valeur du courant de veille (le courant de veille est le courant qui subsiste dans le réseau électrique d'un véhicule au repos), la tension, l'état de charge et la température de la batterie. Le boîtier 25 transmet ensuite les valeurs mesurées au calculateur principal 3 pour les ajouter aux données initiales. Ce complément de données permet de faciliter le diagnostic de l'énergie électrique du véhicule.

Le dispositif comprend en outre l'outil de diagnostic 7 qui est indépendant du véhicule 1 et qui permet à l'opérateur d'établir un diagnostic consécutivement à une « panne batterie ».

L'outil de diagnostic 7 intègre également plusieurs gammes (la gamme dépend du type de véhicule 1). Ces gammes sont traitées de façon automatisée par une unité de post-traitement 45. La gamme appropriée est lancée par l'unité de post-traitement 45 et le technicien peut la suivre de manière interactive. Chaque action est validée par l'affirmative ou par la négative.

L'outil de diagnostic 7 comprend une unité centrale 17, des moyens d'acquisition et d'écriture 21 des données, une interface homme - machine 23 permettant de faire le lien entre l'opérateur et l'outil de diagnostic 7 et une unité de post-traitement 45.

L'outil de diagnostic est relié au calculateur principal 3 par des moyens de connexion 19.

L'invention consiste notamment en un procédé d'aide au diagnostic en deux étapes successives : une étape de prétraitement 27 et une étape de post-traitement 29 illustrées sur la figure 2.

L'étape de prétraitement 27 intervient lors de l'utilisation du véhicule lorsque celui-ci est en état de fonctionnement. L'étape de post-traitement 29 intervient au moment où le véhicule 1 tombe en panne.

Lors de l'étape de prétraitement 27, des données 33 relatives à la sollicitation des ressources énergétiques du véhicule par son utilisateur sont mesurées et/ou calculées en tant que grandeurs physiques. La figure 2 illustre cette étape de recueil 31 des données 33.

On distingue parmi les données 33 deux types de données distinctes :
- des premières données 33a sont disponibles à tout moment et peuvent être enregistrées de façon systématique dans la mémoire tournante 11 a. figure 1 est une figure schématique du dispositif selon l'invention. Les données 33a incluent également les consommations électriques estimées des organes à l'arrêt (en Ah ou Ampère heure). Ces consommations sont obtenues à l'aide d'un estimateur qui, en fonction des organes présents sur le véhicule, établit une valeur de consommation électrique pour chaque phase de vie du véhicule à l'arrêt. Une phase de vie peut correspondre à une phase durant laquelle les réseaux électriques sont éveillés, une phase durant laquelle les réseaux électriques du véhicule sont en veille ou encore une phase durant laquelle le contact est établi par l'actionnement de la clé par l'utilisateur du véhicule.
- des deuxièmes données 33b ne sont pas toujours disponibles au moment de l'enregistrement. C'est le cas notamment de certaines données caractéristiques de la batterie 26 telles que l'état de charge de la batterie (SOC = State Of Charge). L'état de charge de la batterie est une donnée qui, si elle est estimée, n'est disponible qu'après huit heures d'arrêt du véhicule 2. En revanche, l'état de charge de la batterie peut également être mesuré (et non plus estimé) par le boîtier d'état de charge 25, si celui-ci se trouve dans le véhicule. L'enregistrement est effectué si l'arrêt est d'une durée supérieure à huit heures ou si la variation de l'état de charge est significative. Lorsque les données 33b sont disponibles, elles sont enregistrées dans la mémoire tournante 11 b.

Les données 33 sont enregistrées afin de permettre de reconstituer les conditions d'utilisation du véhicule 1 en termes de consommation énergétique. Elles donnent un aperçu des phases de charge et de décharge de la batterie du véhicule et des consommations énergétiques à l'arrêt.

A titre d'exemple, les données 33a sont notamment les suivantes : la durée de la phase au cours de laquelle le générateur de courant rentrant dans la batterie du véhicule est opérationnel (« générateur opérationnel » ou GO), la durée de la phase au cours de laquelle le générateur n'est pas opérationnel (« générateur non opérationnel » ou GNO), la durée de saturation de l'alternateur en phase GO, le nombre de kilomètres parcourus, la durée de maintien des réseaux éveillés par une condition dite « définitive » (clé en position contact, feux allumés, etc.) et la condition de maintien associées, la présence d'un maintien anormal des réseaux et la fonction ou l'organe à l'origine du maintien, les mauvais démarrages (nombre de démarrage manqués ou dont la durée est inférieure à un temps référence), la défaillance alternateur (Présence ou absence d'un défaut auto-diagnostiqué), etc. Les données 33a peuvent également comprendre la température de la batterie, le courant de veille minimal.

La valeur de consommation électrique multipliée par le temps de chaque phase de vie donne une estimation de la consommation (en Ah) du véhicule. Avec le même principe, une valeur de consommation est attribuée à chaque fonction activable par l'utilisateur du véhicule (activation de la radio, des feux, etc.) et, en la multipliant par le temps d'activation, on obtient une autre valeur de consommation qui peut être ajoutée à la précédente. Ces valeurs de consommation sont réparties dans plusieurs compteurs (consommation des feux, consommation de la radio, etc.) dans lesquels elles sont enregistrées. Cela permet de mieux discerner l'origine d'une consommation élevée.

Les données 33b sont notamment les suivantes : l'état de charge de la batterie (exprimé en pourcentage de charge) et la variation de cet état de charge durant la phase GNO.

Après l'étape 31, un enregistrement 35 de ces données 33 est réalisé sur la mémoire tournante 11 sous certaines conditions.

Tout d'abord, un enregistrement 35 des données 33a est effectué de façon systématique à chaque « roulage » ainsi que des données 33b lorsque celles-ci sont disponibles.

Par ailleurs, un enregistrement 35 de ces données 33 est également réalisé lorsque la tension estimée ou mesurée de la batterie du véhicule est inférieure à une tension seuil prédéterminée Us et des données 33 si elles sont disponibles. La tension estimée de la batterie est en réalité la tension d'alimentation Ubsi du calculateur principal du véhicule. En effet, la valeur de la tension de la batterie est sensiblement identique à la tension d'alimentation Ubsi du véhicule 1. Par conséquent, il n'est pas indispensable de mesurer cette valeur directement.

Ces données 33a et 33b enregistrées consécutivement à un roulage, ou lorsque Ubsi est inférieure à Us, constituent une série de données 37.

Les deux types d'enregistrement (enregistrement à chaque roulage et enregistrement lorsque Ubsi est inférieure à Us) sont réalisés sur la mémoire tournante 11.

Après un premier roulage, une première série de données 37 est enregistrée puis, après un deuxième roulage, une deuxième série de données 37 est enregistrée et ainsi de suite jusqu'à un nombre maximum de roulages. Le nombre maximum de roulages est de préférence vingt.

Lorsque ce nombre maximum de roulages est atteint, la première série de données 37 enregistrée est effacée au profit de la vingt-et-unième puis au vingt-deuxième roulage, la deuxième série de données 37 est effacée au profit de la vingt-deuxième série et ainsi de suite. On ne conserve sur la mémoire tournante 11 en permanence qu'un nombre limité de séries de données 37 en tout et pour tout (20 séries de données 37 dans l'exemple cité).

Enfin, lorsque la tension de la batterie Ubsi est inférieure à la tension seuil Us, un archivage 39 de tout ou partie des séries de données 37 enregistrées est demandé puis réalisé au démarrage suivant pour constituer les séries de données 37.

L'étape de prétraitement 27 a permis de recueillir et d'enregistrer des séries de données utiles pour réaliser l'étape de post-traitement 29.

L'étape de post-traitement 29 comporte principalement quatre étapes successives : une étape d'acquisition de séries de données 41, une étape d'analyse des données 43, une étape de détermination de l'origine possible de la panne 47 et une étape de préconisation d'une action corrective 49.

Lors de l'étape du post-traitement 29, qui intervient au moment où le véhicule 1 doit subir une intervention suite à une panne batterie, les séries de données enregistrées et les séries de données archivées sont récupérées par des moyens de connexion 19 reliant le véhicule 1 à l'unité centrale 17 et des moyens d'acquisition. Il s'agit de l'étape d'acquisition 41.

L'outil de diagnostic 7 lit alors les données 37 dans le calculateur principal du véhicule et les mémorise.

L'étape d'analyse des données 43 consiste en une comparaison des données acquises suite à l'étape de prétraitement 27 aux valeurs de référence relatives au dimensionnement électrique du véhicule fournies par le constructeur du véhicule afin de vérifier leur conformité. Cette étape 43 est réalisée par l'unité de post-traitement 45 de l'outil de diagnostic 7.

Le technicien branche alors l'outil de diagnostic 7 sur le véhicule 1 à l'aide des moyens de connexion 19 (par exemple à l'aide d'une prise diagnostic du véhicule 1) puis il acquiert les séries de données 37 grâce aux moyens d'acquisition 21 (par exemple à l'aide de requêtes de transmission de données) et enfin il lance l'unité de post-traitement 45 qui permet de réaliser une analyse assistée de la « panne batterie ».

L'étape de détermination de l'origine de la panne 47 permet au technicien de connaître les raisons pour lesquelles une panne batterie est survenue. Cette étape est réalisée par l'outil de diagnostic 7.

La dernière étape de préconisation d'une action corrective 49 est réalisée par l'intermédiaire de l'interface homme machine 23 afin de permettre de remédier à la panne.

Par exemple, si un maintien dit « abusif » des réseaux électriques par une fonction ou un organe a été enregistré, c'est-à-dire un maintien anormalement long, l'outil de diagnostic affiche l'anomalie au technicien pour orienter son analyse vers la fonction ou l'organe correspondant.

Si la valeur du courant de veille minimum mesuré est différente d'un seuil calibré (ce seuil est fonction du véhicule), le technicien est alerté par l'outil de diagnostic.

Les consommations du véhicule 1 en phase « GNO » sont surveillées et estimées puis enregistrées de façon différenciée selon leur origine. Une consommation « hors normes » à l'arrêt peut ainsi être mise en évidence et son origine également. Par exemple, il est possible de mettre en évidence une décharge de la batterie causée par un oubli d'extinction des feux du véhicule. D'autre part, le recoupement des informations de consommation avec celles du maintien définitif des réseaux et de la durée de ce maintien va permettre de préciser encore l'origine de la surconsommation. Par exemple, on pourra déterminer la valeur de consommation des feux à l'arrêt en Ah puis préciser, grâce à la condition de maintien définitive, qu'il s'agit d'un oubli des feux de position qui a duré au moins x minutes.

Un autre recoupement est réalisé entre les données enregistrées relatives aux consommations et celles relatives à l'évolution de l'état de charge de la batterie. Si les consommations du véhicule estimées ne sont pas en adéquation avec la valeur de la variation de l'état de charge de la batterie (mesurée en pourcentage de charge) estimée ou mesurée, plusieurs origines de surconsommation peuvent être déduites (surconsommation en veille ou consommation non surveillée par exemple peuvent expliquer la décharge non signalée par l'estimation de la consommation à l'arrêt).

Les données enregistrées relatives à l'état de charge de la batterie et à sa variation pendant la phase d'arrêt permettent de déterminer si la contribution du roulage en terme d'énergie est positive ou négative et s'il est donc potentiellement responsable de la panne ou non. Le programme d'aide au diagnostic détermine alors s'il doit, ou non, analyser les données relatives à ce roulage.

A partir de la durée en GO et de la durée pendant laquelle l'alternateur est saturé, l'outil peut déterminer la durée en GO de charge effective de la batterie. Ensuite, en comparant les durées de charge effective et les durées de stationnement (en GNO), l'outil peut déterminer si l'équilibre entre les phases de charge et de décharge de la batterie est correct. Si ce n'est pas le cas, ou si les durées de stationnement dépassent un certain seuil ou si les durées de charges effectives sont trop courtes, l'outil remonte une alerte sur l'interface homme machine 23.

Grâce notamment à des données comme le kilométrage et l'indice du roulage qui sont également enregistrés, l'outil de diagnostic est capable de corréler temporellement les enregistrements des données 33a et des données 33b pour réaliser l'analyse.

Dans l'optique de rendre fiable l'analyse faite par l'outil de diagnostic 7, les seuils de l'analyse sont adaptés en fonction du contexte du roulage analysé (température de la batterie en début de roulage, forte consommation vue précédemment, etc.).

De même, l'outil est apte à prévenir le technicien si une coupure batterie a été détectée ou s'il n'y a pas eu de tension Ubsi critique pendant les derniers roulages enregistrés.

L'interface homme machine 23 est également constituée de manière à ce que les messages communiqués au technicien soient filtrés par ordre d'importance (par exemple priorisation d'une alerte de défaillance d'un organe par rapport à l'affichage d'une alerte pour une décharge imputable à l'utilisateur du véhicule)

L'utilisation d'un tel procédé d'aide au diagnostic simplifie le travail du technicien dans la mesure où il n'a plus besoin de reprendre la gamme systématiquement à son commencement du fait de l'automatisation de celle-ci.

En outre, une fois la gamme lancée, il n'y a plus de dialogue avec le véhicule. Le technicien peut alors débrancher l'outil du véhicule pour poursuivre son analyse.

## Revendications

1. Procédé d'aide au diagnostic d'une panne batterie d'un véhicule (1), notamment automobile, comportant une première étape de prétraitement (27) consistant à recueillir des données (33) représentatives de l'utilisation de l'énergie électrique du véhicule lors de son utilisation et une deuxième étape de post-traitement (29) consistant à analyser les données (37) lors d'une panne du véhicule afin d'en identifier l'origine **caractérisé en ce que** l'étape de prétraitement (27) comporte les étapes suivantes :
a. recueil et/ou calcul (31) des données (33) ;
b. enregistrement (35) sur une mémoire tournante (11) des données (33) afin de constituer une série de données (37) soit :
i. consécutivement à l'intervalle de temps séparant deux démarrages du véhicule et/ou
ii. lorsque les données (33) à enregistrer sont disponibles et/ou
iii. lorsque la tension d'alimentation du calculateur principal du véhicule (Ubsi) est inférieure à une tension seuil (Us) prédéterminée et
c. archivage (39) des séries de données (37) sur une mémoire d'archivage (13) lorsque la tension (Ubsi) est inférieure à une tension seuil (Us).

2. Procédé d'aide au diagnostic selon la revendication 1 **caractérisé en ce que** l'étape de prétraitement (27) permet d'enregistrer jusqu'à 20 séries de données (37) sur une mémoire tournante (11).

3. Procédé d'aide au diagnostic selon la revendication 1 **caractérisé en ce que** l'étape de prétraitement (27) permet d'archiver jusqu'à 20 séries de données (37) sur une mémoire d'archivage (13).

4. Procédé d'aide au diagnostic selon l'une des revendications précédentes **caractérisé en ce que** l'étape de post-traitement (29) comporte les étapes suivantes :
a. acquisition (41) des séries de données (37) enregistrées et archivées lors de l'étape de prétraitement ;
b. analyse des données (43) ;
c. détermination (47) de l'origine possible de la panne et
d. préconisation d'une action corrective (49).

5. Procédé d'aide au diagnostic selon l'une des revendications précédentes **caractérisé en ce que** les valeurs de la tension, de l'état de charge et de la température de la batterie (26) sont mesurées ou estimées puis transmises au calculateur principal (3) du véhicule (1) pour être ajoutées aux données (33).

6. Procédé d'aide au diagnostic selon l'une des revendications précédentes **caractérisé en ce que** la valeur du courant de veille est mesurée et transmise au calculateur principal (3) du véhicule (1) pour être ajoutée aux données (33).

7. Procédé d'aide au diagnostic selon la revendication 4 **caractérisé en ce que** l'analyse des données (43) réalisée lors de l'étape de post-traitement (29) consiste à comparer les données acquises aux données de référence relatives au dimensionnement électrique du véhicule (1) fournies par le constructeur du véhicule afin de vérifier leur conformité.

8. Procédé d'aide au diagnostic selon la revendication 4 ou 7 **caractérisé en ce que** l'analyse des données réalisée lors de l'étape de post-traitement (29) consiste à comparer la durée d'alimentation d'une fonction ou d'un organe du véhicule à la durée d'alimentation préconisée par le constructeur du véhicule.

9. Procédé d'aide au diagnostic selon les revendications 4, 7 ou 8 **caractérisé en ce que** l'analyse des données réalisée lors de l'étape de post-traitement (29) consiste à comparer la valeur du courant de veille minimum mesurée à la valeur du courant de veille préconisée par le constructeur du véhicule.

10. Procédé d'aide au diagnostic selon les revendications 4, 7, 8 ou 9 **caractérisé en ce que** la consommation électrique moyenne du véhicule durant une phase de vie est estimée et catégorisée lors de l'étape de post-traitement (29) afin de permettre d'identifier l'origine d'une consommation électrique élevée.

11. Procédé d'aide au diagnostic selon la revendication 4 **caractérisé en ce qu'**une alerte est affichée sur l'interface homme machine (23) lorsque les données ne sont pas conformes aux données de référence.

12. Procédé d'aide au diagnostic selon la revendication 4 ou 11 **caractérisé en ce qu'**une alerte est affichée sur l'interface homme machine (23) lorsque la tension (Ubsi) n'a pas excédé la tension seuil (Us) pendant les derniers roulages enregistrés.

13. Procédé d'aide au diagnostic selon la revendication 4, 11 ou 12 **caractérisé en ce qu'**une alerte est affichée sur l'interface homme machine (23) lorsqu'il y a eu une coupure de la tension (Ubsi) alimentant la batterie au cours des derniers roulages enregistrés.

14. Procédé d'aide au diagnostic selon la revendication 4, 11, 12 ou 13 **caractérisé en ce que** les alertes émises sont triées par degré de priorité et affichées sur l'interface homme machine (23) selon cet ordre de priorité.

15. Dispositif adapté à la mise en oeuvre du procédé d'aide au diagnostic conforme aux revendications 1 à 7 comprenant un calculateur principal (3), une mémoire non-volatile (5) et un outil de diagnostic (7) **caractérisé en ce que** la mémoire non-volatile (5) comporte une partie dédiée à une mémoire tournante (11) et une partie dédiée à une mémoire d'archivage (13).

16. Dispositif selon la revendication 15 **caractérisé en ce qu'**il comprend des capteurs (15) aptes à capturer des données (33) provenant du véhicule (1).

17. Dispositif selon les revendications 15 à 16 **caractérisé en ce que** l'outil de diagnostic (7) est relié au calculateur principal (3) par des moyens de connexion (19) et **en ce qu'**il comprend une unité centrale (17), des moyens d'acquisition et d'écriture (21) des données (33), une interface homme machine (23) permettant de faire le lien entre l'opérateur et l'outil de diagnostic (7) et une unité de post-traitement (45).

18. Dispositif selon les revendications 15 à 18 **caractérisé en ce que** l'outil de diagnostic (7) est adapté à la réalisation des étapes du post-traitement (29).

## Claims

1. Method to help diagnose battery failure in a vehicle (1), particularly a motor vehicle, involving a preprocessing first step (27) that consists in gathering data (33) representative of the use by the vehicle of electrical energy while the vehicle is in use, and a post-processing second step (29) that consists in analysing the data (37) in the event of vehicle failure in order to identify the origin of this failure, **characterized in that** the preprocessing step (27) involves the following steps:
a. gathering and/or calculating (31) data (33);
b. recording (35) the data (33) in a dynamic memory to form a data set (37) either:
i. after the period of time separating two vehicle starts and/or
ii. when the data (33) for recording is available and/or
iii. when the supply voltage of the vehicle main computer (Ubsi) is below a said voltage threshold (Us), and
c. archiving (39) the data sets (37) in an archive memory (13) when the voltage (Ubsi) is below a threshold voltage (Us).

2. Method to help with diagnosis according to Claim 1, **characterized in that** the preprocessing step (27) allows up to 20 data sets (37) to be recorded in a dynamic memory (11).

3. Method to help with diagnosis according to Claim 1, **characterized in that** the preprocessing step (27) allows up to 20 data sets (37) to be archived in an archive (13).

4. Method to help with diagnosis according to one of the preceding claims, **characterized in that** the post-processing step (29) involves the following steps:
a. acquiring (41) the data sets (37) recorded and archived during the preprocessing step;
b. analysing the data (43);
c. determining (47) the possible cause of the failure, and
d. recommending a corrective action (49).

5. Method to help with diagnosis according to one of the preceding claims, **characterized in that** the values of voltage, charge level and temperature of the battery (26) are measured or estimated then transmitted to the main computer (3) of the vehicle (1) to be added to the data (33).

6. Method to help with diagnosis according to one of the preceding claims, **characterized in that** the intensity of the standby current is measured and transmitted to the main computer (3) of the vehicle (1) to be added to the data (33).

7. Method to help with diagnosis according to Claim 4, **characterized in that** the data analysis (43) performed during the post-processing step (29) consists in comparing the acquired data against reference data relating to the electrical rating of the vehicle (1) which data is provided by the vehicle manufacturer in order to check for compliance therewith.

8. Method to help with diagnosis according to Claim 4 or 7, **characterized in that** the data analysis performed during the post-processing step (29) consists in comparing the length of time for which a function or a member of the vehicle is supplied with power against the length of power application period recommended by the vehicle manufacturer.

9. Method to help with diagnosis according to Claims 4, 7 or 8, **characterized in that** the data analysis performed during the post-processing step (29) consists in comparing the minimum measured standby current intensity with the standby current intensity recommended by the vehicle manufacturer.

10. Method to help with diagnosis according to Claims 4, 7, 8 or 9, **characterized in that** the mean electrical power consumption of the vehicle during a phase of its life is estimated and categorized during the post-processing step (29) so as to allow the origin of a high electrical power consumption to be identified.

11. Method to help with diagnosis according to Claim 4, **characterized in that** a warning is displayed on the man-machine interface (23) when the data is inconsistent with the reference data.

12. Method to help with diagnosis according to Claim 4 or 11, **characterized in that** a warning is displayed on the man-machine interface (23) when the voltage (Ubsi) has not exceed the threshold voltage (Us) for the last few journeys recorded.

13. Method to help with diagnosis according to Claim 4, 11 or 12, **characterized in that** a warning is displayed on the man-machine interface (23) when there been a break in the voltage (Ubsi) supplied to the battery during the last few journeys recorded.

14. Method to help with diagnosis according to Claim 4, 11, 12 or 13, **characterized in that** the warnings transmitted are sorted into priority order and displayed on the man-machine interface (23) in this order of priority.

15. Device for implementing the method for helping with diagnosis according to Claims 1 to 7, comprising a main computer (3), a non-volatile memory (5) and a diagnostics tool (7), **characterized in that** the non-volatile memory (5) comprises a part dedicated a dynamic memory (11) and a part dedicated to an archival memory (13).

16. Device according to Claim 15, **characterized in that** it comprises sensors (15) able to collect data (33) originating from the vehicle (1).

17. Device according to Claims 15 to 16, **characterized in that** the diagnostics tool (7) is connected to the main computer (3) by connecting means (19), and **in that** it comprises a central unit (17), data (33) acquisition and writing means (21), a man-machine interface (23) providing the connection between the operator and the diagnostics tool (7,) and a post-processing unit (45).

18. Device according to Claims 15 to 18, **characterized in that** the diagnostics tool (7) is suited to carrying out the steps of the post-treatment (29).

## Patentansprüche

1. Hilfsverfahren für die Diagnostik einer Batteriepanne eines Fahrzeugs (1), insbesondere eines Kraftfahrzeugs, das einen ersten Vorverarbeitungsschritt (27) aufweist, der darin besteht, die Daten (33), die für den Gebrauch der elektrischen Energie des Fahrzeugs bei seinem Gebrauch repräsentativ sind, zu sammeln, und einen zweiten Schritt der Nachverarbeitung (29), der darin besteht, die Daten (37) bei einer Panne des Fahrzeugs zu analysieren, um den Ursprung der Panne zu identifizieren, **dadurch gekennzeichnet, dass** der Vorverarbeitungsschritt (27) die folgenden Schritte aufweist:
a. Sammeln und/oder Berechnen (31) der Daten (33);
b. Aufzeichnen (35) auf einem Umlaufspeicher (11) der Daten (33), um eine Datenfolge (37) zusammenzustellen, das heißt:
i. nach dem Zeitabstand, der zwei Startvorgänge des Fahrzeugs trennt und/oder
ii. wenn die zu speichernden Daten (33) verfügbar sind und/oder
iii. wenn die Versorgungsspannung des Hauptrechners des Fahrzeugs (Ubsi) geringer ist als eine vorbestimmte Schwellenspannung (Us) und
c. Archivieren (39) der Datenfolgen (37) auf einem Archivierungsspeicher (13), wenn die Spannung (Ubsi) kleiner ist als eine Schwellenspannung (Us).

2. Hilfsverfahren für die Diagnostik nach Anspruch 1, **dadurch gekennzeichnet, dass** es der Vorverarbeitungsschritt (27) erlaubt, bis zu 20 Datenfolgen (37) auf einem Umlaufspeicher (11) zu speichern.

3. Hilfsverfahren für die Diagnostik nach Anspruch 1, **dadurch gekennzeichnet, dass** es der Vorverarbeitungsschritt (27) erlaubt, bis zu 20 Datenfolgen (37) auf einem Archivierungsspeicher (13) zu archivieren.

4. Hilfsverfahren für die Diagnostik nach einem der vorhergehenden Ansprüche, **dadurch gekennzeichnet, dass** der Nachverarbeitungsschritt (29) die folgenden Schritte aufweist:
a. Erfassen (41) der Datenfolgen (37), die bei dem Vorverarbeitungsschritt gespeichert und archiviert wurden;
b. Analyse der Daten (43);
c. Bestimmen (47) des möglichen Ursprungs der Panne und
d. Empfehlen einer behebenden Aktion (49).

5. Hilfsverfahren für die Diagnostik nach einem der vorhergehenden Ansprüche, **dadurch gekennzeichnet, dass** die Werte der Spannung, der Ladezustand und die Temperatur der Batterie (26) gemessen oder geschätzt und dann an den Hauptrechner (3) des Fahrzeugs (1) übertragen werden, um zu den Daten (33) hinzugefügt zu werden.

6. Hilfsverfahren für die Diagnostik nach einem der vorhergehenden Ansprüche, **dadurch gekennzeichnet, dass** der Wert des Standbystroms gemessen und an den Hauptrechner (3) des Fahrzeugs (1) übertragen wird, um zu den Daten (33) hinzugefügt zu werden.

7. Hilfsverfahren für die Diagnostik nach Anspruch 4, **dadurch gekennzeichnet, dass** die Analyse der Daten (43), die bei dem Nachverarbeitungsschritt (29) ausgeführt wird, darin besteht, die erfassten Daten mit Referenzdaten in Zusammenhang mit der elektrischen Bemessung des Fahrzeugs (1), die von dem Hersteller des Fahrzeugs geliefert werden, zu vergleichen, um ihre Konformität zu prüfen.

8. Hilfsverfahren für die Diagnostik nach Anspruch 4 oder 7, **dadurch gekennzeichnet, dass** die Analyse der Daten, die bei dem Nachverarbeitungsschritt (29) ausgeführt wird, darin besteht, die Versorgungsdauer einer Funktion oder eines Organs des Fahrzeugs mit der Versorgungsdauer zu vergleichen, die von dem Hersteller des Fahrzeugs empfohlen wird.

9. Hilfsverfahren für die Diagnostik nach den Ansprüchen 4, 7 oder 8, **dadurch gekennzeichnet, dass** die Analyse der Daten, die bei dem Nachverarbeitungsschritt (29) ausgeführt wird, darin besteht, den Wert des gemessenen Mindeststandbystroms mit dem Wert des Standbystroms, der von dem Hersteller des Fahrzeugs empfohlen wird, zu vergleichen.

10. Hilfsverfahren für die Diagnostik nach den Ansprüchen 4, 7, 8 oder 9, **dadurch gekennzeichnet, dass** der mittlere Stromverbrauch des Fahrzeugs während einer Lebensphase geschätzt und bei dem Nachverarbeitungsschritt (29) klassifiziert wird, um es zu ermöglichen, den Ursprung eines hohen Stromverbrauchs zu identifizieren.

11. Hilfsverfahren für die Diagnostik nach Anspruch 4, **dadurch gekennzeichnet, dass** auf der Bediener-Maschinenschnittstelle (23) eine Warnung angezeigt wird, wenn die Daten nicht den Referenzdaten entsprechen.

12. Hilfsverfahren für die Diagnostik nach Anspruch 4 oder 11, **dadurch gekennzeichnet, dass** auf der Bediener-Maschinenschnittstelle (23) eine Warnung angezeigt wird, wenn die Spannung (Ubsi) den Spannungsschwellenwert (Us) während der zuletzt aufgezeichneten Fahrten nicht überschritten hat.

13. Hilfsverfahren für die Diagnostik nach Anspruch 4, 11 oder 12, **dadurch gekennzeichnet, dass** auf der Bediener-Maschinenschnittstelle (23) eine Warnung angezeigt wird, wenn eine Unterbrechung der Spannung (Ubsi), die die Batterie versorgt, im Laufe der zuletzt aufgezeichneten Fahrten aufgetreten ist.

14. Hilfsverfahren für die Diagnostik nach Anspruch 4, 11, 12 oder 13, **dadurch gekennzeichnet, dass** die ausgegebenen Warnungen nach Vorrang sortiert und auf der Bediener-Maschinenschnittstelle (23) gemäß dieser Vorrangsreihenfolge angezeigt werden.

15. Vorrichtung, die zum Umsetzen des Hilfsverfahrens für die Diagnostik nach den Ansprüchen 1 bis 7 geeignet ist, die einen Hauptrechner (3), einen nicht flüchtigen Speicher (5) und ein Diagnosewerkzeug (7) aufweist, **dadurch gekennzeichnet, dass** der nicht flüchtige Speicher (5) einen Teil aufweist, der einem Umlaufspeicher (11) zugewiesen ist, und einen Teil, der einem Archivierungsspeicher (13) zugewiesen ist.

16. Vorrichtung nach Anspruch 15, **dadurch gekennzeichnet, dass** sie Sensoren (15) aufweisen kann, die Daten (33), die von dem Fahrzeug (1) kommen, erfassen können.

17. Vorrichtung nach den Ansprüchen 15 bis 16, **dadurch gekennzeichnet, dass** das Diagnosewerkzeug (7) mit dem Hauptrechner (3) durch Verbindungsmittel (19) verbunden ist, und dass sie eine Zentraleinheit (17), Mittel zum Erfassen und zum Schreiben (21) der Daten (33), eine Bediener-Maschinenschnittstelle (23), die es erlaubt, die Verbindung zwischen dem Bediener und dem Diagnosewerkzeug (7) herzustellen, und eine Nachverarbeitungseinheit (45) aufweist.

18. Vorrichtung nach den Ansprüchen 15 bis 18, **dadurch gekennzeichnet, dass** das Diagnosewerkzeug (7) die Schritte der Nachverarbeitung (29) ausführen kann.
